# EUROPEAN PATENT APPLICATION

(11) **EP 3 495 532 A1**
(43) Date of publication of application: **12.06.2019**
(21) Application number: 18180958.3
(22) Date of filing: 29.06.2018
(51) Int. Cl.: C23C 14/00, H01L 31/0224

(54) **METHOD FOR PREPARING LAMINATED FILM AND LAMINATED FILM**

(30) Priority: 08.12.2017 CN 201711298658
(71) Applicant: Miasolé Equipment Integration (Fujian) Co., Ltd., 362000 Quanzhou Fujian (CN)
(72) Inventor: TIAN, Jing, QUANZHOU, Fujian 362000 (CN); QU, Minghao, QUANZHOU, Fujian 362000 (CN); HU, Chao, QUANZHOU, Fujian 362000 (CN); HUANG, Chaohsiung, QUANZHOU, Fujian 362000 (CN); WU, Jianqing, QUANZHOU, Fujian 362000 (CN); XU, Guojun, QUANZHOU, Fujian 362000 (CN)
(74) Representative: Cabinet Beau de Loménie

(57) **Abstract**

The present disclosure relates to a laminated film and a method for manufacturing the laminated film. The method includes: depositing (S1) a first film layer on a substrate; forming (S2) a porous force-release contact layer on the first film layer; and forming (S3) a second film layer on the force-release contact layer, wherein the first film layer is a metal layer and the second film layer is a semiconductor layer, or the first film layer is a semiconductor layer and the second film layer is a metal layer.

## Description

### TECHNICAL FIELD

The present disclosure relates to the technologies for manufacturing solar cells, and in particular, to a method for preparing a laminated film and a laminated film.

### BACKGROUND

Currently, in the current field of manufacturing semiconductor devices such as photovoltaics, flat panel displays, etc., in order to meet the multiple needs of products, magnetron sputtering film technology is widely used to prepare and obtain complex devices with specific functions. Therefore, in the actual processes, two or more layers of different materials with different functionalities need to be laminated. The laminated film structures of the metal and semiconductor are widely used as front and back contact electrode structures.

Metal and semiconductor materials have significant differences in mechanical and electrical properties. When they are contacted in the form of film to form an interface, severe physical property mismatches tend to occur at the interface. In the related art, after the metal film layer is formed, the inherent stress state causes a strain at the interface between the metal film layer and the semiconductor film layer, which causes the film layers to peel off from each other and thereby affect the production quality.

### SUMMARY

An objective of the present disclosure is to provide a method for preparing a laminated film and a laminated film, so as to enhance the adhesive force between the metal film layer and the semiconductor film layer, avoid peeling off of film layers and thereby improve production quality.

An embodiment of the present disclosure provides a method for preparing a laminated film, including:
depositing a first film layer on a substrate;
forming a porous force-release contact layer on the first film layer; and
forming a second film layer on the force-release contact layer, wherein the first film layer is one of a metal layer and a semiconductor layer, and the second film layer is the other of the metal layer and the semiconductor layer.

In the above method for preparing a laminated film, the forming the porous force-release contact layer on the first film layer includes:

depositing the force-release contact layer composed of an elementary substance (simple substance) on the first film layer.

In the above method for preparing a laminated film, the forming the porous force-release contact layer on the first film layer includes:

forming the force-release layer composed of a compound by a chemical reaction.

In the above method for preparing a laminated film, the material of the force-release contact layer composed of the elementary substance includes one of copper, silver, iron, aluminum, tungsten, molybdenum, chromium, nickel, tantalum, vanadium, titanium and manganese.

In the above method for preparing a laminated film, the forming the force-release layer composed of the compound by the chemical reaction includes:

adding an oxygen element to perform reactive sputtering so as to obtain the force-release contact layer of an epitaxial structure.

In the above method for preparing a laminated film, the adding the oxygen element to perform the reactive sputtering includes:

introducing solid steam of oxygen or sulfur or selenium.

In the above method for preparing a laminated film, the adding the oxygen element to perform the reactive sputtering includes:

introducing gaseous oxygen or gaseous sulfur or gaseous selenium.

In the above method for preparing a laminated film, a working pressure for depositing the force-release contact layer is between 0.5 Pa and 2 Pa.

Another embodiment of the present disclosure provides a laminated film, including:
a metal layer;
a force-release contact layer having a porous structure; and
a semiconductor layer;
wherein the force-release contact layer is disposed between the metal layer and the semiconductor layer.

In the above laminated film, wherein the force-release contact layer has the porous structure which includes micro-pores or mesoporouses.

In the above laminated film, the force-release contact layer has a thickness of 10 nm to 1000 nm.

In the laminated film layer and the method for manufacturing the same provided by embodiments of the present disclosure, by depositing a force-release contact layer, the stress between the metal layer and the semiconductor layer is released, thereby avoiding peeling off of film layers and improving production quality.

### BRIEF DESCRIPTION OF THE DRAWINGS

Fig. 1 is a flow chart showing a method for manufacturing a laminated film according to an embodiment of the present disclosure.
Fig. 2 is a schematic diagram showing a cross-sectional structure of a laminated film according to an embodiment of the present disclosure.

### DETAILED DESCRIPTION

Embodiments of the present disclosure are described in detail below, examples of which are illustrated in the accompanying drawings, in which the same or similar reference numerals denote the same or similar elements or elements having the same or similar functions throughout. The embodiments described below with reference to the drawings are exemplary, are used only to explain the present disclosure, and cannot be construed as limiting the present disclosure.

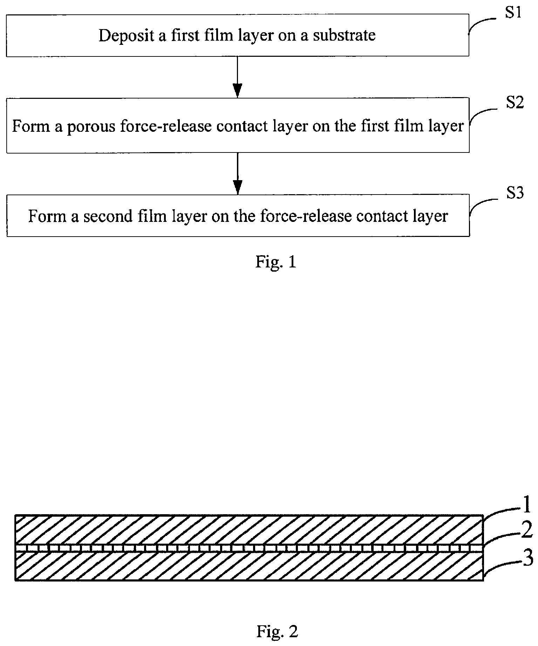

As shown in Fig. 1, an embodiment of the present disclosure provides a method for manufacturing a laminated film (laminated thin film), which includes the following steps:
In S1, a first film layer is deposited on a substrate.
In S2, a porous force-release contact layer is formed on the first film layer.
In S3, a second film layer is formed on the force-release contact layer, wherein the first film layer is one of a metal layer and a semiconductor layer, and the second film layer is the other of the metal layer and the semiconductor layer..

In the above steps, a metal layer may be first deposited on the substrate, and then a semiconductor layer may be formed on the force-release contact layer; alternatively, a semiconductor layer may be deposited on the substrate first, and accordingly a metal layer is formed on the force-release contact layer.

In the method for manufacturing the laminated film provided by the embodiments of the present disclosure, by depositing a force-release contact layer, the stress between the metal layer and the semiconductor layer is released, thereby avoiding peeling off of the film layers and improving the production quality.

In an example, the forming a porous force-release contact layer on the first film layer comprises: directly depositing the force-release contact layer composed of a simple substance on the first film layer; or forming the force-release layer composed of a compound by a chemical reaction.

Specifically, the depositing of the force-release contact layer is generally conducted within the range of 2 times or more of the sputtering pressure of the normal metal electrode layer and below the starting pressure. In this embodiment, the working pressure for depositing the force-release contact layer is between 0.5 Pa and 2 Pa. For example, the working pressure may be 0.5Pa, 0.8Pa, 1Pa, 1.1Pa, 1.3Pa, 1.5Pa, 1.75Pa, 1.9Pa, 2Pa, etc., detailed description of which will not be given here. Compared with sputtering with a relatively high working pressure, the probability of loss of kinetic energy due to scattering of sputtered particles is relatively large, and the formed film structure is relatively porous with a certain porosity, and the microscopic stress of the film can be easily released under this structure. On the macroscopic side, there is no obvious internal stress, so that the peeling off of the metal or the semiconductor film layer can be avoided.

The desired epitaxial structure may be obtained by adding an oxygen element to perform the reactive sputtering according to the characteristics of the semiconductor layer and the metal layer. The introduction of the oxygen element may include introducing a solid steam of oxygen or sulfur or selenium, may include introducing gaseous oxygen or gaseous sulfur or gaseous selenium.

For obtaining the best integrated interface performance, the force-release contact layer may be made of material different from that of the metal layer, and may include one of copper, silver, iron, aluminum, tungsten, molybdenum, chromium, nickel, tantalum, vanadium, titanium, and manganese. Alternatively, the force-release contact layer may also be a compound formed after the metal layer or the semiconductor layer chemically reacts with the introduced oxygen element.

As shown in Fig. 2, an embodiment of the present disclosure also provides a laminated film, including: a metal layer 1, a force-release contact layer 2 having a loose and porous structure, and a semiconductor layer 3. The force-release contact layer 2 is disposed between the metal layer 1 and the semiconductor layer 3. The force-release contact layer 2 is obtained by the preparation method provided in the embodiments of the present disclosure, so that the stress between the metal layer 1 and the semiconductor layer 3 can be released, peeling off of the film layers can be avoided, and the production quality can be improved.

Those skilled in the art can understand that in order to clearly show the relationship between the film layers, Fig. 2 is not drawn in proportion to the actual thicknesses of the film layers.

In the laminated film provided by the embodiments of the present disclosure, a force-release contact layer with a thickness of 10 nm to 1000 nm may be prepared through the above method. The contact layer may be a porous structure of microporous or mesoporous, and the microscopic stress of the film layer can be easily released in this structure. And, there is no obvious internal stress on the macroscopic side, so that peeling off of the metal layer or the semiconductor film layer can be avoided.

The thickness of the force-release contact layer may be 10 nm, 200 nm, 400 nm, 800 nm, 850 nm, 900 nm, 1000 nm, etc., detailed descriptions of which will not be provided here.

The above-mentioned micropores are pores having a pore diameter of less than 2 nm as defined by the International Union of Pure and Applied Chemistry (IUPAC).

## Claims

1. A method for preparing a laminated film, comprising:
depositing (S1) a first film layer on a substrate;
forming (S2) a porous force-release contact layer on the first film layer; and
forming (S3) a second film layer on the force-release contact layer, wherein the first film layer is one of a metal layer and a semiconductor layer, and the second film layer is the other of the metal layer and the semiconductor layer.

2. The method according to claim 1, wherein the forming (S2) the porous force-release contact layer on the first film layer comprises:
depositing the force-release contact layer composed of an elementary substance on the first film layer, or forming the force-release layer composed of a compound by a chemical reaction.

3. The method according to claim 2, wherein a material of the force-release contact layer composed of the elementary substance comprises one of copper, silver, iron, aluminum, tungsten, molybdenum, chromium, nickel, tantalum, vanadium, titanium and manganese.

4. The method according to claim 2, wherein the forming the force-release layer composed of the compound by the chemical reaction comprises:
adding an oxygen element to perform reactive sputtering so as to obtain the force-release contact layer of an epitaxial structure.

5. The method according to claim 4, wherein the adding the oxygen element to perform the reactive sputtering comprises:
introducing solid steam of oxygen or sulfur or selenium.

6. The method according to claim 4, wherein the adding the oxygen element to perform the reactive sputtering comprises:
introducing gaseous oxygen or gaseous sulfur or gaseous selenium.

7. The method according to claim 2, wherein a working pressure for depositing the force-release contact layer is between 0.5 Pa and 2 Pa.

8. The method according to claim 7, wherein the working pressure for depositing the force-release contact layer is 0.5 Pa, 0.8 Pa, 1 Pa, 1.1 Pa, 1.3 Pa, 1.5 Pa, 1.75 Pa, 1.9. Pa or 2Pa.

9. A laminated film comprising:
a metal layer (1);
a force-release contact layer (2) having a porous structure; and
a semiconductor layer (3);
wherein the force-release contact layer (2) is disposed between the metal layer (1) and the semiconductor layer (3).

10. The laminated film according to claim 9, wherein the force-release contact layer (2) has the porous structure having micro-pores or mesoporouses.

11. The laminated film according to claim 9 or 10, wherein the force-release contact layer (2) has a thickness of 10 nm to 1000 nm.
